(19) Europäisches Patentamt / European Patent Office / Office européen des brevets

(11) **EP 4 498 785 A1**

(12) **EUROPEAN PATENT APPLICATION**
published in accordance with Art. 153(4) EPC

(43) Date of publication:
**29.01.2025   Bulletin 2025/05**

(21) Application number: **23796055.4**

(22) Date of filing: **07.04.2023**

(51) International Patent Classification (IPC):
*H10N 30/079* (2023.01)      *H03H 9/17* (2006.01)
*H03H 9/25* (2006.01)        *H10N 30/40* (2023.01)
*H10N 30/85* (2023.01)       *H10N 30/853* (2023.01)

(52) Cooperative Patent Classification (CPC):
**H10N 30/8542; H03H 9/17; H03H 9/174;**
**H03H 9/25; H10N 30/708; H10N 30/877;**
**H10N 30/878;** H10N 30/076; H10N 30/079

(86) International application number:
**PCT/JP2023/014441**

(87) International publication number:
**WO 2023/210309 (02.11.2023 Gazette 2023/44)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority:  **27.04.2022   JP 2022073801**

(71) Applicant: **I-PEX Piezo Solutions Inc.**
**Ube-shi, Yamaguchi 755-0152 (JP)**

(72) Inventors:
• **IIZUKA, Takeshi**
  **Ube-shi, Yamaguchi 755-0152 (JP)**
• **ANDO, Akira**
  **Ube-shi, Yamaguchi 755-0152 (JP)**
• **KONISHI, Akio**
  **Ube-shi, Yamaguchi 755-0152 (JP)**

(74) Representative: **Kraus & Lederer PartGmbB**
**Thomas-Wimmer-Ring 15**
**80539 München (DE)**

(54) **FILM STRUCTURE AND ELECTRONIC DEVICE**

(57)      A film structure (10) includes a Si layer (12a), a ZrO$_2$ layer (12b), which is a buffer film containing ZrO$_2$, formed on the Si layer (12a), and a piezoelectric film (11) formed on the ZrO$_2$ layer (12b). The Si layer 12a is an SOI layer on a Si(100) substrate or an SOI substrate including a base made of a Si substrate, an insulating layer on the base, and an SOI layer made of a Si(100) film on the insulating layer. The piezoelectric film (11) includes c-axis oriented LiNbO$_3$ or LiTaO$_3$.

*FIG. 3*

EP 4 498 785 A1

**Description**

TECHNICAL FIELD

The present invention relates to a film structure and an electronic device.

BACKGROUND ART

There has been known a film structure including a substrate and a piezoelectric film formed on the substrate, and an electronic device including the film structure. As the piezoelectric film, there has been known a piezoelectric film having an ilmenite structure such as lithium niobate ($LiNbO_3$).

JP2013-173647A (Patent Literature 1) discloses a technique in which, in a dielectric laminated thin film, at least one epitaxially grown base film containing zirconium oxide ($ZrO_2$) as a main component is formed on a single crystal Si(111) substrate surface, and an epitaxially grown ilmenite structure film made of a dielectric material with an ilmenite structure is formed on the base film.

JP2016-109856A (Patent Literature 2) discloses a technique including a single crystal substrate, a dielectric layer, and a buffer layer provided between the single crystal substrate and the dielectric layer, in which the dielectric layer is lithium niobate ($LiNbO_3$) or lithium tantalate ($LiTaO_3$), a c-axis of a crystal constituting the dielectric layer is substantially parallel to a main surface of the single crystal substrate, the buffer layer is hexagonal $LiNbO_2$ or $LiTaO_2$, and a c-axis of a crystal constituting the buffer layer is substantially parallel to the main surface of the single crystal substrate.

PRIOR ART DOCUMENTS

PATENT LITERATURE

Patent Literature 1: JP2013-173647A
Patent Literature 2: JP2016-109856A

SUMMARY OF INVENTION

PROBLEM TO BE SOLVED BY THE INVENTION

In the technique described in Patent Literature 1, a $LiNbO_3$ film, which is a piezoelectric film, is c-axis oriented on the Si(111) substrate, and a polarization direction of the piezoelectric film is oriented perpendicularly to the substrate. In this way, the polarization direction of the piezoelectric film having an ilmenite structure can be aligned on the Si(111) substrate in a direction perpendicular to the substrate. On the other hand, it may be preferable to align a polarization direction of a piezoelectric film having an ilmenite structure on a Si(100) substrate, which is a commonly used and inexpensive semi-conductor substrate, instead of using the Si(111) substrate, in a direction perpendicular to the substrate. However, it is difficult to align an orientation direction of the piezoelectric film having an ilmenite structure on the Si (100) substrate in the direction perpendicular to the substrate.

The present invention has been made in order to solve the problems in the conventional art as described above. An object of the present invention is to provide a film structure including a substrate and a piezoelectric film formed on the substrate, in which even when the substrate is a Si(100) substrate and the piezoelectric film has an ilmenite structure, a polarization direction of the piezoelectric film can be aligned in a direction perpendicular to the substrate.

MEANS FOR SOLVING THE PROBLEM

An outline of a representative one of the inventions disclosed in the present application will be briefly described as follows.

A film structure according to one aspect of the present invention includes a substrate, a buffer film formed over the substrate, and a piezoelectric film formed over the buffer film. The substrate is a Si(100) substrate, or an SOI substrate including a base made of a Si substrate, an insulating layer over the base, and an SOI layer made of a Si(100) film over the insulating layer. The buffer film contains $ZrO_2$. The piezoelectric film contains c-axis oriented $LiNbO_3$ or $LiTaO_3$.

As another aspect, the film structure may include a metal film formed between the buffer film and the piezoelectric film.

As another aspect, the metal film may contain (100)-oriented Pt.

As another aspect, the metal film may be a Pt film, a Mo film, a W film, a Ru film, or a Cu film.

As another aspect, the film structure may include a $SrRuO_3$ film formed between the metal film and the piezoelectric film, and the $SrRuO_3$ film may have a cubic crystal structure and be (100)-oriented.

An electronic device according to one aspect of the present invention is an electronic device including the film structure.

An electronic device according to one aspect of the present invention is an electronic device including the film structure. The film structure includes a comb-teeth electrode formed at an upper surface or a lower surface of the piezoelectric film.

As another aspect, the film structure may include a matching layer formed over the substrate.

As another aspect, a hollow portion may be provided below the piezoelectric film.

As another aspect, the film structure may include an upper electrode formed above the piezoelectric film and a lower electrode formed below the piezoelectric film.

As another aspect, an area of an overlapping portion of the upper electrode and the lower electrode may be smaller than an area of the hollow portion.

As another aspect, an area of an overlapping portion of the upper electrode and the lower electrode may be equal to or smaller than 1/2 of an area of the hollow portion.

As another aspect, the film structure may include a matching layer formed over the substrate.

As another aspect, the matching layer may be made of a material whose hardness increases with an increase in temperature.

As another aspect, the material may be a Si compound.

EFFECTS OF INVENTION

By applying one aspect of the present invention, in a film structure including a substrate and a piezoelectric film formed on a substrate, even when the substrate is a Si(100) substrate and the piezoelectric film has an ilmenite structure, a polarization direction of the piezoelectric film can be aligned in a direction perpendicular to the substrate.

BRIEF DESCRIPTION OF DRAWINGS

FIG. 1 is a cross-sectional view of a film structure of Embodiment 1.
FIG. 2 is a cross-sectional view of the film structure of Embodiment 1.
FIG. 3 is a cross-sectional view of the film structure of Embodiment 1.
FIG. 4 is a cross-sectional view of the film structure of Embodiment 1.
FIG. 5 is a cross-sectional view of the film structure of Embodiment 1.
FIG. 6 is a cross-sectional view of the film structure of Embodiment 1.
FIG. 7 is a cross-sectional view of an electronic device of Embodiment 2.
FIG. 8 is a cross-sectional view of the electronic device of Embodiment 2.
FIG. 9 is a cross-sectional view of the electronic device of Embodiment 2.
FIG. 10 is a cross-sectional view of the electronic device of Embodiment 2.
FIG. 11 is a cross-sectional view of the electronic device of Embodiment 2.
FIG. 12 is a cross-sectional view of the electronic device of Embodiment 2.
FIG. 13 is a cross-sectional view of the electronic device of Embodiment 2.
FIG. 14 is a cross-sectional view of the electronic device of Embodiment 2.
FIG. 15 is a perspective view of an electronic device of Embodiment 3.
FIG. 16 is a perspective view of the electronic device of Embodiment 3.
FIG. 17 is a perspective view of the electronic device of Embodiment 3.
FIG. 18 is a diagram showing a crystal structure of c-axis oriented $LiNbO_3$.
FIG. 19 is a graph showing an example of an $\omega$-$2\theta$ spectrum of a film structure in Example 1, which is obtained by an XRD method.
FIG. 20 is a graph showing an example of an $\omega$-$2\theta$ spectrum of a film structure in Example 2, which is obtained by the XRD method.
FIG. 21 is a graph showing an example of an $\omega$-$2\theta$ spectrum of a film structure in Example 3, which is obtained by the XRD method.
FIG. 22 is a graph showing a result of a reciprocal lattice map measurement of the film structure in Example 1.
FIG. 23 is a graph showing a result of a reciprocal lattice map measurement of the film structure in Example 2.
FIG. 24 is a graph showing an example of an $\varphi$ scan spectrum of the film structure in Example 1, which is obtained by the XRD method.
FIG. 25 is a graph showing an example of an $\varphi$ scan spectrum of the film structure in Example 2, which is obtained by the XRD method.
FIG. 26 shows a table in which symmetry of an apparent crystal structure determined by the number of diffraction peaks observed in the $\varphi$ scan spectrum is classified and sorted by a rotational angle of a rotational component and symmetry of a crystal structure including a hexagonal crystal and a trigonal crystal.
FIG. 27 is a graph showing voltage dependence of polarization of the film structure in Example 2.

EMBODIMENTS FOR CARRYING OUT THE INVENTION

Hereinafter, embodiments of the present invention will be described with reference to the drawings.

The disclosure is merely an example, and any modifications that can be easily conceived by those skilled in the art while maintaining the spirit of the invention are naturally included within the scope of the present invention. In order to make the description more clear, the drawings may be schematically illustrated with respect to a width, thickness, shape, and the like of each part as compared with the embodiment, but are merely examples and do not limit the interpretation of the present invention.

In the present description and each drawing, elements same as those described above in relation to the previously shown drawings are denoted by the same reference numerals, and detailed descriptions may be omitted as appropriate.

Further, in the drawings used in the embodiments, hatching (shading) for distinguishing structures may be omitted depending on the drawing.

In the following embodiments, when a range is indicated as A to B, the range is A or more and B or less, unless otherwise specified.

(Embodiment 1)

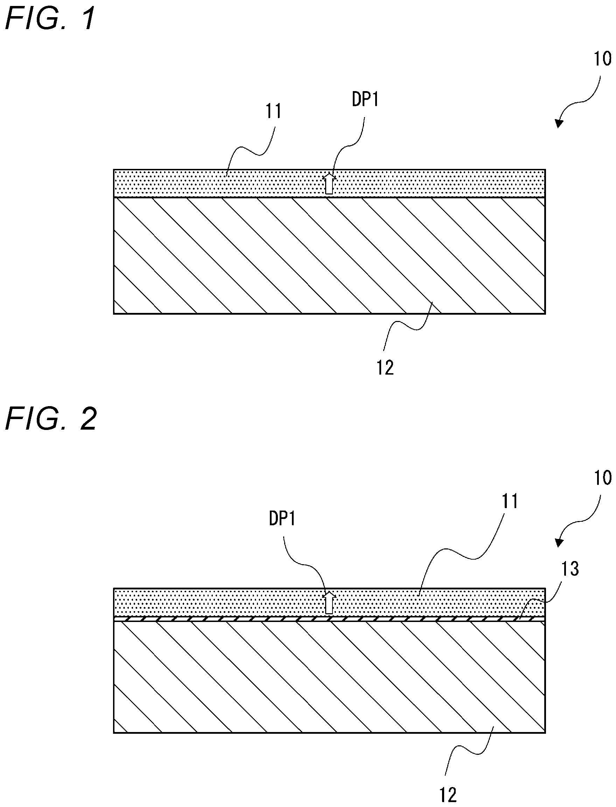

First, a film structure of Embodiment 1, which is one embodiment of the present invention, will be described. FIGS. 1 to 6 are cross-sectional views of the film structure of Embodiment 1.

As shown in FIG. 1, a film structure 10 of the present Embodiment 1 is a film structure including a piezoelectric film 11 and a substrate 12, in which a polarization direction of the piezoelectric film 11, that is, a piezoelectric film portion is preferentially oriented perpendicularly to the substrate 12. In FIG. 1, the polarization direction is indicated by a polarization direction DP1 (the same applies to FIGS. 2 and 7 to 17). Since the polarization direction of the piezoelectric film 11 is preferentially oriented perpendicularly to the substrate 12, a film structure in which a polarization direction of a piezoelectric film is aligned in a direction perpendicular to a substrate can be implemented.

Alternatively, as shown in FIG. 2, the film structure 10 of the present Embodiment 1 is a film structure including the piezoelectric film 11, an electrode 13, and the substrate 12, in which a polarization direction of the piezoelectric film 11, that is, a piezoelectric film portion is preferentially oriented perpendicularly to the substrate 12. As described above, since the polarization direction of the piezoelectric film 11 is preferentially oriented perpendicularly to the substrate 12, a film structure in which a polarization direction of a piezoelectric film is aligned in a direction perpendicular to a substrate can be implemented.

In the present description, the fact that the polarization direction of the piezoelectric film 11 is preferentially oriented perpendicularly to the substrate 12 means that a portion of the piezoelectric film 11 that is oriented such that the polarization direction is perpendicular to the substrate 12 exceeds 50% of the entire piezoelectric film 11, for example, in terms of volume fraction. For example, it means that when a $\theta$-$2\theta$ spectrum is measured by an X-ray diffraction (XRD) method, in the measured $\theta$-$2\theta$ spectrum, a peak intensity of a maximum peak indicating a portion oriented such that the polarization direction is perpendicular to the substrate 12 is higher than a peak intensity of a maximum peak indicating a portion not oriented such that the polarization direction is perpendicular to the substrate 12. The case where the polarization direction is perpendicular to the substrate 12 includes not only a case where the polarization direction is completely perpendicular to the upper surface of the substrate 12 but also a case where an angle formed by a direction perpendicular to the upper surface of the substrate 12 and the polarization direction is 20° or less.

In the film structure 10 of the present Embodiment 1, the piezoelectric film 11 contains c-axis oriented lithium niobate ($LiNbO_3$, hereinafter also referred to as "LN") or lithium tantalate ($LiTaO_3$), that is, contains c-axis oriented $LiNbO_3$ or $LiTaO_3$ as a main component. Alternatively, in the film structure 10 of the present Embodiment 1, the piezoelectric film 11 may contain a solid solution of c-axis oriented lithium niobate ($LiNbO_3$) or lithium tantalate ($LiTaO_3$), or may include the solid solution of c-axis oriented $LiNbO_3$ or $LiTaO_3$ as a main component. $LiNbO_3$ or $LiTaO_3$ has an ilmenite structure, which is a trigonal crystal structure, and is polarized in a c-axis direction.

By c-axis orientation of $LiNbO_3$ or $LiTaO_3$, $LiNbO_3$ or $LiTaO_3$ can be oriented such that the c-axis direction, which is a polarization direction of $LiNbO_3$ or $LiTaO_3$, is perpendicular to the substrate 12.

In the present description, the fact that the piezoelectric film 11 contains $LiNbO_3$ or $LiTaO_3$ as a main component means that a content of $LiNbO_3$ or $LiTaO_3$ in the piezoelectric film 11 exceeds 50 wt% or the content of $LiNbO_3$ or $LiTaO_3$ in the piezoelectric film 11 exceeds 50 mol%.

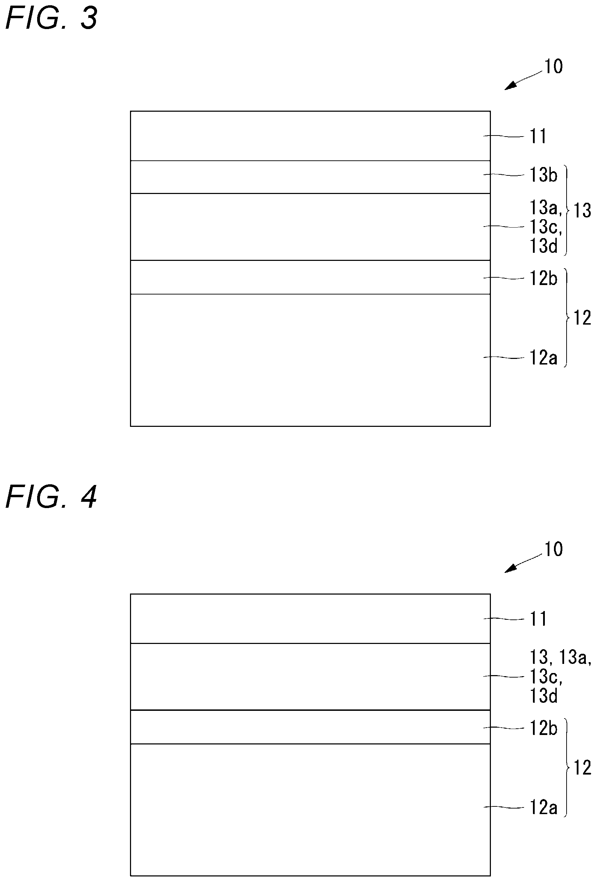

As shown in FIG. 3, the substrate 12 preferably has a structure in which a Si layer and a $ZrO_2$ layer are laminated in this order. Si represents silicon, and $ZrO_2$ represents zirconium oxide. $ZrO_2$ plays a role as a buffer film, and contributes to forming a piezoelectric material formed thereon with good crystallinity. That is, since the buffer film contains $ZrO_2$ formed on the Si layer, the polarization direction of the piezoelectric film can be aligned in the direction perpendicular to the substrate, and an orientation direction of the piezoelectric film can also be aligned in an in-plane direction along the upper surface of the substrate.

The substrate 12 preferably includes a (100)-oriented Si layer 12a and a $ZrO_2$ layer 12b formed on the Si layer 12a. The $ZrO_2$ layer 12b preferably contains (200)-oriented $ZrO_2$ and (002)-oriented $ZrO_2$. As the Si layer 12a of the substrate 12, a (100)-oriented Si substrate, that is, a Si(100) substrate can be used. In such a case, the polarization direction of the piezoelectric film 11 such as the piezoelectric film 11 containing c-axis oriented lithium niobate or lithium tantalate as a main component is oriented perpendicularly to the substrate 12, and the epitaxially grown piezoelectric film 11 can be easily formed on the substrate 12. The (100)-oriented Si substrate can be used as the Si layer 12a of the substrate 12, and thus an electronic device in which a polarization direction of the piezoelectric film 11 is aligned in a direction perpendicular to a substrate and an orientation direction of the piezoelectric film is also aligned in an in-plane direction along an upper surface of the substrate can be formed on an inexpensive semi-conductor substrate. That is, even when the substrate is a Si(100) substrate and the piezoelectric film has an ilmenite structure, the polarization direction of the piezoelectric film can be aligned in a direction perpendicular to the substrate.

As shown in FIG. 3, the electrode 13 has a structure in which a Pt(200) layer, that is, a Pt(100) layer, and a $SrRuO_3(100)$ layer are laminated in this order. Pt represents platinum, and $SrRuO_3$ (SRO) represents strontium ruthenium oxide. In other words, the electrode 13 preferably includes a Pt layer 13a formed on the substrate 12 and (200)-oriented, that is, (100)-oriented, and an SRO layer ($SrRuO_3$ film) 13b formed on the Pt layer 13a, having a cubic crystal structure, and (100)-oriented. That is, a metal film (Pt layer 13a) contains (100)-oriented Pt, the $SrRuO_3$ film is formed between the metal film (Pt layer 13a) and the piezoelectric film 11, and the $SrRuO_3$ film (SRO layer 13b) has a cubic crystal structure and is (100)-oriented. In such a case, the piezoelectric film 11 containing c-axis oriented $LiNbO_3$ or $LiTaO_3$ as a main component can be easily formed on the substrate 12 with the electrode 13 serving as a lower electrode therebetween.

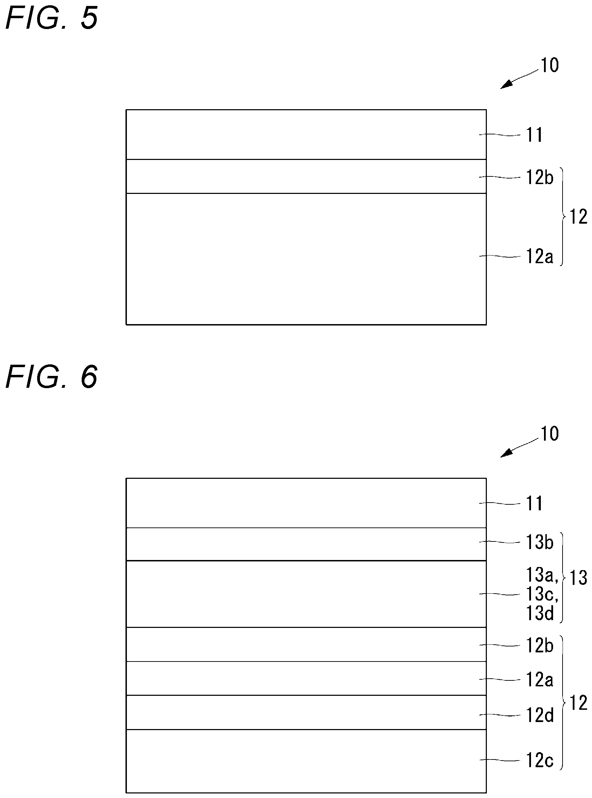

As shown in FIG. 4, the electrode 13 may include only the Pt(200) layer, that is, the Pt(100) layer (Pt layer 13a), without including the $SrRuO_3(100)$ layer. As shown in FIG. 1, when the film structure 10 of the present Embodiment 1 does not have the electrode 13 (see FIG. 2), the piezoelectric film 11 may be directly formed on the $ZrO_2$ layer 12b as shown in FIG. 5.

It is not limited to the case where the Si layer 12a is (100)-oriented, it is not limited to the case where the $ZrO_2$ layer 12b is (200)-oriented or (002)-oriented, it is not limited to the case where the Pt layer 13a is (200)-oriented, and it is not limited to the case where the electrode 13 includes the SRO layer 13b formed on the Pt layer 13a and (100)-oriented.

For example, the substrate 12 may include the (111)-oriented Si layer 12a and the $ZrO_2$ layer 12b formed on the Si layer 12a. The $ZrO_2$ layer 12b preferably contains, for example, (111)-oriented $ZrO_2$. As the Si layer 12a of the substrate 12, a (111)-oriented Si substrate, that is, a Si(111) substrate can be used. In such a case, the piezoelectric film 11 containing c-axis oriented $LiNbO_3$ or $LiTaO_3$ as a main component can be easily formed on the substrate 12. The electrode 13 includes the Pt layer 13a formed on the substrate 12 and (111)-oriented.

The Si layer 12a of the substrate 12 can be regarded as a substrate. In such a case, the film structure 10 of the present Embodiment 1 is a film structure including the substrate (Si layer 12a), which is a Si substrate, the buffer film ($ZrO_2$ layer 12b) formed on the substrate (Si layer 12a) and containing $ZrO_2$, and the piezoelectric film 11 formed on the buffer film ($ZrO_2$ layer 12b) with the metal film (Pt layer 13a) therebetween, in which the piezoelectric film 11 contains c-axis oriented $LiNbO_3$ or $LiTaO_3$, and the polarization direction of the piezoelectric film 11 is preferentially oriented perpendicularly to the upper surface of the substrate 12. The piezoelectric film 11 is a piezoelectric film formed on $Pt/ZrO_2/Si$. Accordingly, the metal film (Pt layer 13a) is formed between the buffer film ($ZrO_2$ layer 12b) and the piezoelectric film 11. When the electrode 13 includes the Pt layer 13a and the SRO layer 13b, that is, when the film structure 10 further includes the metal film (Pt layer 13a) on the buffer film ($ZrO_2$ layer 12b) and further includes the SRO film (SRO layer 13b) on the metal film (Pt layer 13a), the piezoelectric film 11 is a piezoelectric film formed on the substrate (Si layer 12a), which is a Si substrate, with the $ZrO_2$ film ($ZrO_2$ layer 12b), the Pt film (Pt layer 13a), and the SRO film (SRO layer 13b) therebetween in this order from the bottom.

As shown in FIG. 6, instead of the Si(100) substrate, a silicon on insulator (SOI) substrate, which is a semi-conductor substrate, can be used as the Si layer 12a of the substrate 12. When the SOI substrate is used as the substrate 12, the substrate 12 includes a base 12c made of a Si substrate, a buried oxide (BOX) layer 12d as an insulating layer which is a buried oxide film formed on the base 12c, and the Si layer 12a which is a silicon on insulator (SOI) layer made of a Si(100) film and formed on the BOX layer 12d. Accordingly, a film structure with an excellent dielectric constant characteristic and withstanding voltage characteristic of the piezoelectric film can be formed on the SOI substrate, and an electronic device including a micro electro mechanical system (MEMS) having a plurality of piezoelectric elements formed with high shape accuracy can be easily formed on the SOI substrate.

When the SOI substrate is used instead of the Si(111) substrate, an SOI layer made of a Si(111) film can be used as the (111)-oriented Si layer 12a of the substrate 12.

The Si layer 12a of the substrate 12 can be regarded as a substrate. In such a case, the film structure 10 of the present Embodiment 1 is a film structure including the substrate (Si layer 12a), which is an SOI substrate, the buffer film ($ZrO_2$ layer 12b) formed on the substrate (Si layer 12a) and containing $ZrO_2$, and the piezoelectric film 11 formed on the buffer film ($ZrO_2$ layer 12b) with the metal film (Pt layer 13a) therebetween, in which the piezoelectric film 11 contains c-axis oriented $LiNbO_3$ or $LiTaO_3$, and the polarization direction of the piezoelectric film 11 is preferentially oriented perpendicularly to the upper surface of the substrate 12. The piezoelectric film 11 is a piezoelectric film formed on $Pt/ZrO_2/Si$ of SOI. When the electrode 13 includes the Pt layer 13a and the SRO layer 13b, that is, when the film structure 10 further includes the metal film (Pt layer 13a) on the buffer film ($ZrO_2$ layer 12b) and further includes the SRO film (SRO layer 13b) on the metal film (Pt layer 13a), the piezoelectric film 11 is a piezoelectric film formed on the substrate (Si layer 12a), which is an SOI substrate, with the $ZrO_2$ film ($ZrO_2$ layer 12b), the Pt film (Pt layer 13a), and the SRO film (SRO layer 13b) therebetween in this order from the bottom.

The electrode 13 can also include a Mo layer 13c or a W layer 13d instead of the Pt layer 13a. In such a case, the electrode 13 includes the Mo layer 13c or the W layer 13d, and the SRO layer 13b formed on the Mo layer 13c or the W layer 13d. In such a case, the film structure 10 of the present Embodiment 1 includes the piezoelectric film 11 formed on the substrate (Si layer 12a), which is a Si substrate or an SOI substrate, with the $ZrO_2$ film ($ZrO_2$ layer 12b) and the Mo film (Mo layer 13c) or the W film (W layer 13d) therebetween in this order from the bottom. In such a case, as in the case where the electrode 13 includes the Pt layer 13a, the polarization direction of the piezoelectric film 11, for example, a piezoelectric material containing c-axis oriented $LiNbO_3$ or $LiTaO_3$ as a main component, is oriented perpendicularly to the substrate 12, and the epitaxially grown piezoelectric film 11 can be easily formed on the substrate 12 with the electrode 13 serving as a lower electrode therebetween. In addition to the materials described above, a Ru layer (Ru film) or a Cu layer (Cu film) may be used as the electrodes 13a, 13c, and 13d. These materials are generally used as electrode materials.

(Embodiment 2)

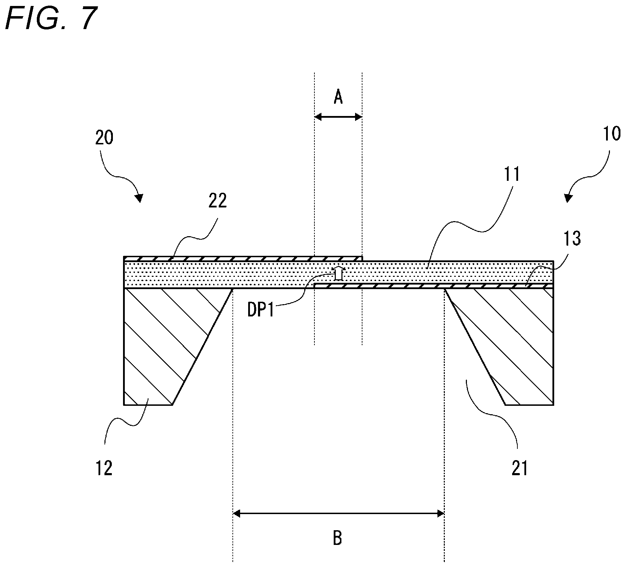

Next, an electronic device of Embodiment 2, which is one embodiment of the present invention, will be described. The electronic device of the present Embodiment 2 is a bulk acoustic wave (BAW) filter or a film bulk acoustic resonator (FBAR) including the film structure of Embodiment 1. FIGS. 7 to 14 are cross-sectional views of the electronic device of Embodiment 2.

As shown in FIG. 7, an electronic device 20 of the present Embodiment 2 is an electronic device including the film structure 10 including the piezoelectric film 11, two electrodes, and the substrate 12, in which a polarization direction of the piezoelectric film 11 is preferentially oriented perpendicularly to the substrate 12.

The film structure 10 provided in the electronic device 20 of the present Embodiment 2 can also include the piezoelectric film 11, the electrode 13, and the substrate 12, similar to the film structure 10 of Embodiment 1. That is, the electronic device 20 of the present Embodiment 2 includes the substrate 12, and the electrode 13 and the piezoelectric film 11 on the substrate 12. Therefore, for the piezoelectric film 11, the electrode 13, and the substrate 12 of the film structure 10, description of portions similar to the piezoelectric film 11, the electrode 13, and the substrate 12 of the film structure 10 of Embodiment 1 may be omitted.

On the other hand, since the electronic device 20 of the present Embodiment 2 is a BAW filter or FBAR including the film structure 10 of Embodiment 1, the substrate 12 is provided with a hollow portion, that is, a hollow portion 21 below the piezoelectric film 11. In such a case, at least a central portion of the piezoelectric film 11 located on the hollow portion 21 is not constrained by the substrate 12 and can vibrate freely, and thus a bulk acoustic wave can be easily generated in the central portion. Since the hollow portion is provided below the piezoelectric film 11, when the substrate 12 is etched from a back side, the Si layer 12a (see FIGS. 3 and 4) provided in the substrate 12 is etched and removed, but the $ZrO_2$ layer 12b provided in the substrate 12 (see FIGS. 3 and 4) remains unetched and can function as an etching stopper film. In FIGS. 7 to 14, illustration of the case where the $ZrO_2$ layer 12b (see FIGS. 3 and 4) remains without being etched is omitted.

In the film structure 10 provided in the electronic device 20 of the present Embodiment 2, an electrode 22 is provided as an upper side electrode or an upper electrode formed above the piezoelectric film 11. In such a case, the electrode 13 is an electrode as a lower side electrode or a lower electrode formed below the piezoelectric film 11. That is, the electrode 22 and the electrode 13 are an upper electrode formed above the piezoelectric film 11 and a lower electrode formed below the piezoelectric film 11, respectively. In the example shown in FIG. 7, electrodes are formed above and below the piezoelectric film 11. The film structure 10 is a film structure including the piezoelectric film 11, two electrodes, i.e., the electrode 13 and the electrode 22, and the substrate 12, in which the polarization direction of the piezoelectric film 11, that is, a piezoelectric film portion is preferentially oriented perpendicularly to the substrate 12. In such a case, by applying a voltage such as an AC voltage between the electrode 13 and the electrode 22, an electric field such as an AC electric field in a thickness direction of the piezoelectric film 11 can be easily applied to the piezoelectric film 11, and a bulk acoustic wave can be easily generated in the piezoelectric film 11. A bulk acoustic wave having a resonance frequency determined depending on an elastic characteristic of the piezoelectric film 11, or the like can be generated or passed, and thus the electronic device 20 can function as a resonator or a filter.

In the present Embodiment 2, as in Embodiment 1, a substrate including the (100)-oriented Si layer 12a (see FIG. 3) and the $ZrO_2$ layer 12b (see FIG. 3) formed on the Si layer 12a can be used as the substrate 12. The $ZrO_2$ layer 12b preferably contains (200)-oriented $ZrO_2$ and (002)-oriented $ZrO_2$. In such a case, the Si layer 12a of the substrate 12 can be regarded as a substrate, and the electronic device 20 of the present Embodiment 2 is an electronic device including the substrate (Si layer 12a), which is a Si substrate, and the electrode 13 and the piezoelectric film 11 on the substrate, in which the polarization direction of the piezoelectric film 11 is preferentially oriented perpendicularly to the substrate 12, and the hollow portion 21 is provided below the piezoelectric film 11.

An area A of an overlapping portion of the upper and lower electrodes is preferably smaller than an area B of the piezoelectric film 11 and the lower electrode that are exposed in the hollow portion. That is, an area of the overlapping portion of the electrode 22 as an upper electrode and the electrode 13 as a lower electrode is smaller than an area of the hollow portion 21. In such a case, a portion of the piezoelectric film 11 to which the electric field in the thickness direction is applied can be reliably separated from the substrate 12 by applying a voltage between the electrode 22 and the electrode 13. Therefore, the portion of the piezoelectric film 11 to which the electric field in the thickness direction is applied is not constrained by the substrate 12 and can vibrate freely, and a bulk acoustic wave can be more easily generated.

An area ratio of the area A of the overlapping portion of the upper and lower electrodes to the area B of the piezoelectric film 11 and the lower electrode that are exposed in the hollow portion, that is, A/B is preferably less than 1/2 or 1/2 or less. That is, the area of the overlapping portion of the electrode 22 as an upper electrode and the electrode 13 as a lower electrode is 1/2 or less of the area of the hollow portion 21. In such a case, by applying a voltage between the electrode 22 and the electrode 13, the portion of the piezoelectric film 11 to which the electric field in the thickness direction is applied can be more reliably separated from the substrate 12. Therefore, the portion of the piezoelectric film 11 to which the electric field in the thickness direction is applied is not further constrained by the substrate 12 and can vibrate more freely, and a bulk acoustic wave can be more easily generated.

As described above, the film structure 10 provided in the electronic device 20 of the present Embodiment 2 can also include the piezoelectric film 11, the electrode 13, and the substrate 12, similar to the film structure 10 of Embodiment 1. Therefore, in the film structure 10 provided in the electronic device 20 of the present Embodiment 2, as in the film structure 10 of Embodiment 1, an SOI substrate, which is a semi-conductor substrate, can also be used instead of the Si substrate as the Si layer 12a (see FIG. 6) of the substrate 12, and the electrode 13 can also include the Mo layer 13c (see FIG. 3) or the W layer 13d (see FIG. 3) instead of the Pt layer 13a (see FIG. 3). In addition to the materials described above, a Ru layer or a Cu layer may be used as the material for the electrodes 13a, 13c, or 13d. These materials are generally used as electrode materials.

In the film structure 10 provided in the electronic device 20 of the present Embodiment 2, as in the film structure 10 of Embodiment 1, the piezoelectric film 11 contains c-axis oriented lithium niobate ($LiNbO_3$) or lithium tantalate ($LiTaO_3$), that is, contains c-axis $LiNbO_3$ or $LiTaO_3$ as a main component.

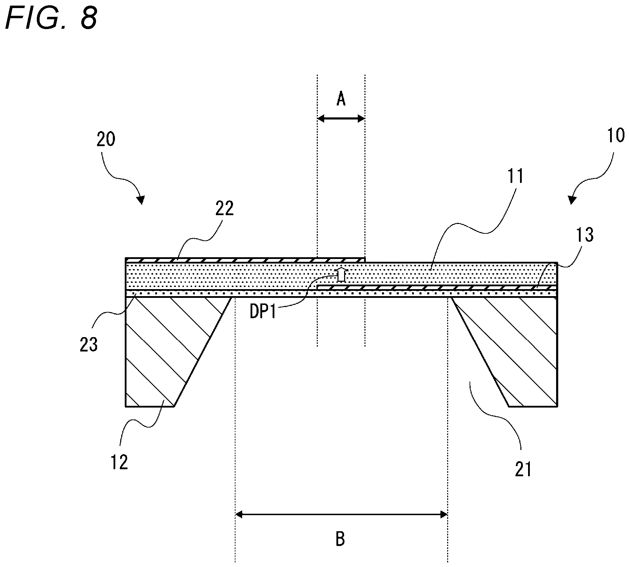

As shown in FIG. 8, it is preferable to provide a dielectric layer or a dielectric layer 23 as a matching layer between the substrate 12 and the piezoelectric film 11. That is, the electronic device 20 shown in FIG. 8 includes, in addition to the portions of the electronic device 20 shown in FIG. 7, the dielectric layer 23 as a matching layer above the substrate 12 and below the lower electrode, that is, below the electrode 13. For example, when a portion of the electronic device 20 other than the dielectric layer 23 is made of a material having a property of being softened together with an increase in temperature and the dielectric layer 23 is made of a material having a property of being hardened together with an increase in temperature, temperature dependence of a dielectric constant characteristic or piezoelectric characteristic of the electronic device 20, that is, temperature characteristics can be stabilized or adjusted.

The dielectric layer 23 is preferably a Si compound, for example, silicon dioxide ($SiO_2$). In such a case, the dielectric layer 23 is a dielectric layer made of a material that is highly compatible with a manufacturing process of a semi-conductor device, and thus the dielectric layer 23 can be easily formed.

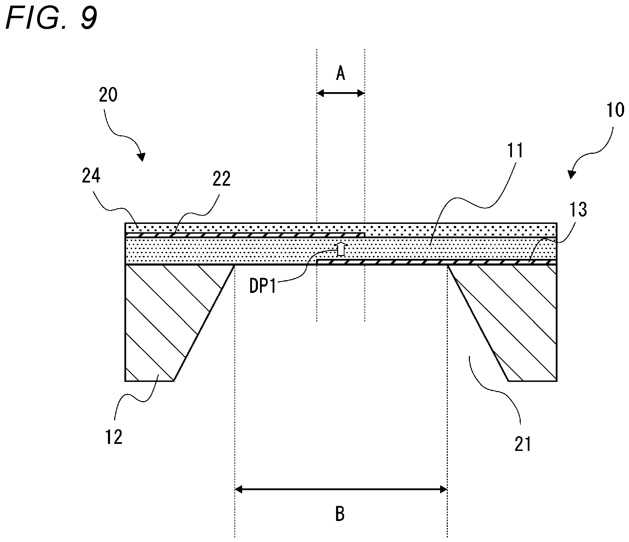

As shown in FIG. 9, it is preferable to provide a dielectric layer 24 as an upper side dielectric layer above the piezoelectric film 11. That is, the electronic device 20 shown in FIG. 9 includes, in addition to the portions of the electronic device 20 shown in FIG. 7, the dielectric layer 24 as an upper side dielectric layer above the piezoelectric film 11. For example, when a portion of the electronic device 20 other than the dielectric layer 24 is made of a material having a property of being softened together with an increase in temperature and the dielectric layer 24 is made of a material having a property of being hardened together with an increase in temperature, the temperature dependence of the dielectric constant characteristic or piezoelectric characteristic of the electronic device 20, that is, the temperature characteristics can be stabilized or adjusted.

The dielectric layer 24 is preferably a Si compound, for example, $SiO_2$. In such a case, the dielectric layer 24 is a dielectric layer made of a material that is highly compatible with a manufacturing process of a semi-conductor device, and thus the dielectric layer 24 can be easily formed.

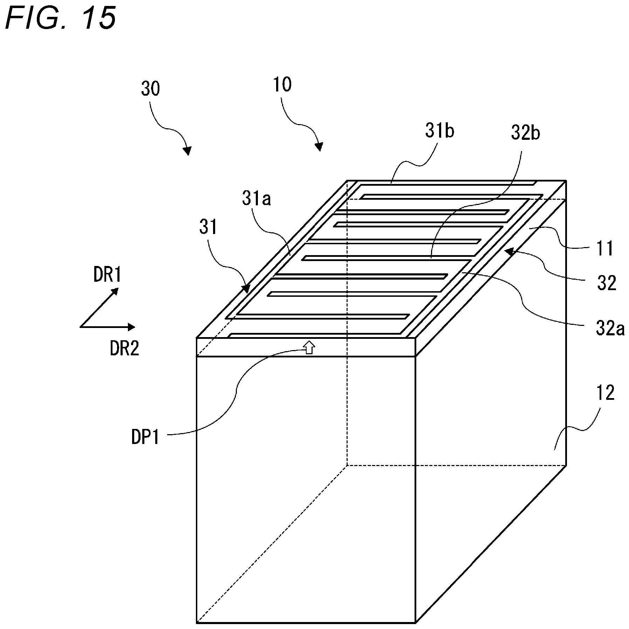

In the examples shown in FIGS. 7 to 9, for example, in the example shown in FIG. 7, either upper or lower side of the piezoelectric film 11 may not be fixed (the same applies to Embodiment 3, which will be described later using FIGS. 15 to 17).

In the examples shown in FIGS. 7 to 9, for example, in the examples shown in FIGS. 8 and 9, either the upper or lower side of the piezoelectric film 11 may be fixed, and an opposite side may be fixed weaker than the other with a material whose hardness changes with temperature. That is, either the upper or lower side of the piezoelectric film 11 may be fixed, and an opposite side of the one of the upper and lower sides of the piezoelectric film 11 may be fixed weakly with a material whose hardness changes with temperature (the same applies to Embodiment 3, which will be described later using FIGS. 15 to 17). Accordingly, an electronic device that utilizes displacement in sliding direction and can compensate for temperature characteristics can be implemented.

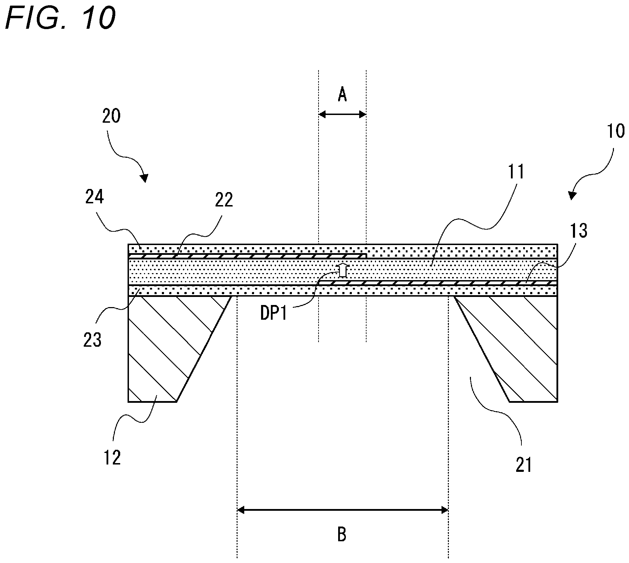

As shown in FIG. 10, it is preferable to provide the dielectric layer 23 as a lower side dielectric layer between the substrate 12 and the piezoelectric film 11 and provide the dielectric layer 24 as an upper side dielectric layer above the piezoelectric film 11. That is, the electronic device 20 shown in FIG. 10 includes, in addition to the portions of the electronic device 20 shown in FIG. 7, the dielectric layer 23 as a matching layer above the substrate 12 and below the lower electrode, that is, below the electrode 13, and the dielectric layer 24 as an upper side dielectric layer above the piezoelectric film 11. In the example shown in FIG. 10, the dielectric layer 24 is provided above the upper electrode, that is, the electrode 22. That is, in the example shown in FIG. 10, electrodes are also formed above and below the piezoelectric film 11. For example, when a portion of the electronic device 20 other than the dielectric layer 23 and the dielectric layer 24 is made of a material having a property of being softened together with an increase in temperature, and the dielectric layer 23 and the dielectric layer 24 are made of a material having a property of being hardened together with an increase in temperature (a material whose hardness increases with an increase in temperature), the temperature dependence of the dielectric constant characteristic or piezoelectric characteristic of the electronic device 20, that is, the temperature characteristics can be stabilized or adjusted. As described above, the dielectric layer 23 and the dielectric layer 24 are a Si compound, for example, $SiO_2$.

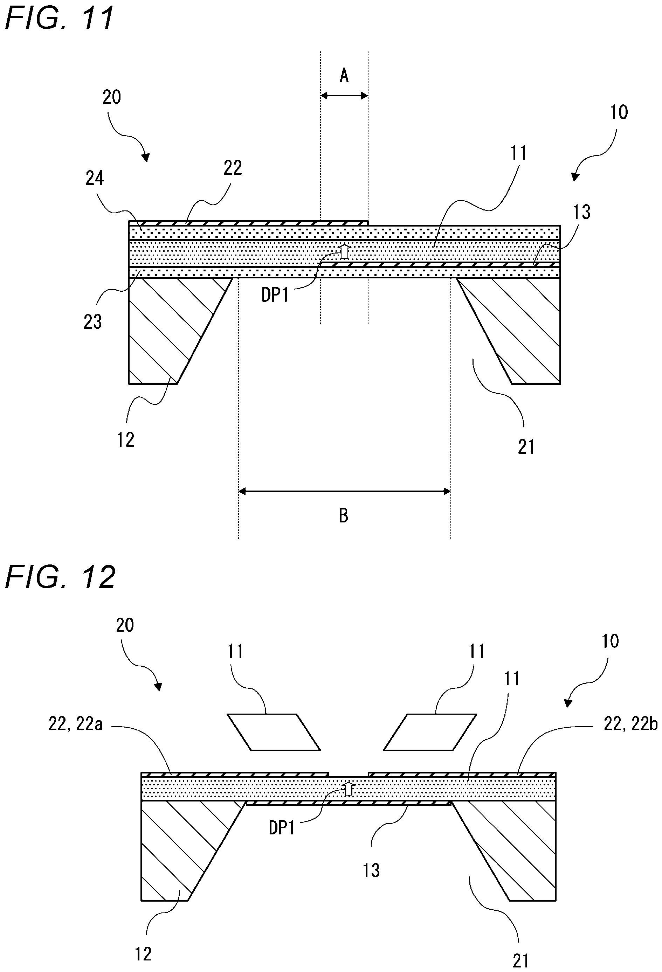

As shown in FIG. 11, it is preferable to provide the dielectric layer 23 as a lower side dielectric layer between the substrate 12 and the piezoelectric film 11, to provide the dielectric layer 24 as an upper side dielectric layer on the piezoelectric film 11, and to provide the electrode 22 as an upper side electrode on the dielectric layer 24 as an upper side dielectric layer. That is, the electronic device 20 shown in FIG. 11 is obtained by reversing a laminating order of the electrode 22 and the dielectric layer 24 in an up-down direction in the electronic device 20 shown in FIG. 10. The structure shown in FIG. 11 is not a structure in which electrodes are formed above and below the piezoelectric film 11. Even in such a case, the effect same as that of the electronic device 20 shown in FIG. 10 can be obtained. As described above, the dielectric layer 23 and the dielectric layer 24 are made of a Si compound, for example, $SiO_2$.

As shown in FIG. 12, it is preferable to have two or more kinds of electric field directions in a plane by providing a plurality of either the upper or lower electrode 13 or electrode 22. In the example shown in FIG. 12, the electronic device 20 includes two electrodes 22 as upper electrodes. In FIG. 12, the two electrodes 22 are shown as an electrode 22a and an electrode 22b. Accordingly, an electronic device that utilizes displacement in sliding direction can be implemented more easily. FIG. 12 schematically shows a case where the piezoelectric film 11 has two types of displacement in sliding direction.

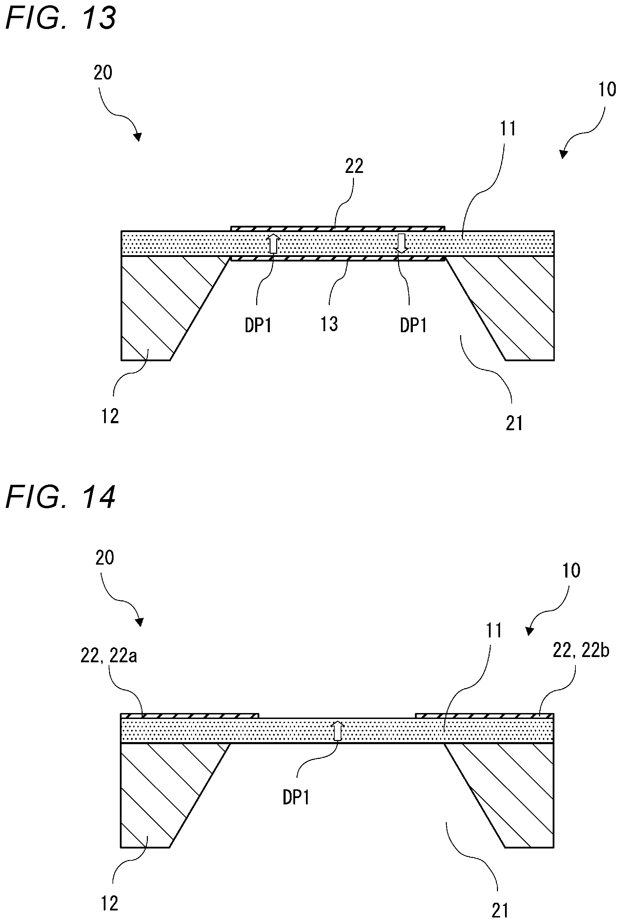

As shown in FIG. 13, it is preferable that the polarization direction (a polarization direction DP1) of the piezoelectric film 11 is preferentially oriented perpendicularly to the substrate 12 in a plurality of directions, and the electrode 22 and the electrode 13 are present on the upper portion and the lower portion of the piezoelectric film 11. In such a case, an electronic device that utilizes displacement in sliding direction can be implemented more easily.

As shown in FIG. 14, it is preferable that a plurality of electrodes are provided above or below the piezoelectric film 11. In the example shown in FIG. 14, the lower electrode is not provided, and two electrodes 22, that is, the electrode 22a and the electrode 22b are provided as the upper electrodes. In such a case, an electronic device that utilizes displacement in sliding direction can be implemented more easily.

(Embodiment 3)

Next, an electronic device of Embodiment 3, which is one embodiment of the present invention, will be described. The electronic device of the present Embodiment 3 is a surface acoustic wave (SAW) filter including the film structure of Embodiment 1. FIGS. 15 to 17 are perspective views of the electronic device of Embodiment 3.

As shown in FIG. 15, an electronic device 30 of the present Embodiment 3 is an electronic device including the film structure 10 including the piezoelectric film 11, a comb-type electrode, and the substrate 12, in which a polarization direction of the piezoelectric film 11 is preferentially oriented perpendicularly to the substrate 12.

The film structure 10 provided in the electronic device 30 of the present Embodiment 3 can also include the piezoelectric film 11 and the substrate 12, similar to the film structure 10 of Embodiment 1. Therefore, for the piezoelectric film 11 and the substrate 12 of the film structure 10, description of portions similar to the piezoelectric film 11 and the substrate 12 of the film structure 10 of Embodiment 1 may be omitted.

On the other hand, since the electronic device 30 of the present Embodiment 3 is a SAW filter including the film structure 10 of Embodiment 1, an electrode 31 and an electrode 32 as comb-type electrodes (comb-teeth electrodes) are formed on an upper surface or a lower surface of the piezoelectric film 11, that is, a piezoelectric body portion. That is, the electronic device 30 of Embodiment 3 includes the substrate 12, and the electrode 31, the electrode 32, and the piezoelectric film 11 on the substrate 12. In such a case, a surface acoustic wave can be easily generated in the piezoelectric film 11 by applying an AC voltage between the electrode 31 and the electrode 32. A surface acoustic wave having a resonance frequency determined depending on elastic characteristics of the substrate 12, the piezoelectric film 11, the electrode 31, and the electrode 32, or the like can be generated or passed, and thus the electronic device 30 can function as a resonator or a filter.

In the present Embodiment 3, as in Embodiment 1, a substrate including the (100)-oriented Si layer 12a (see FIG. 3) and the $ZrO_2$ layer 12b (see FIG. 3) formed on the Si layer 12a can also be used as the substrate 12. The $ZrO_2$ layer 12b preferably contains

(200)-oriented $ZrO_2$ and (002)-oriented $ZrO_2$. In such a case, the Si layer 12a of the substrate 12 can be regarded as a substrate, and the electronic device 30 of the present Embodiment 3 is an electronic device including the substrate (Si layer 12a), which is a Si substrate, and the piezoelectric film 11 on the substrate, in which the polarization direction of the piezoelectric film 11 is preferentially oriented perpendicularly to the substrate 12.

In the example shown in FIG. 15, the electrode 31 and the electrode 32 as comb-type electrodes are formed on the upper surface of the piezoelectric film 11. That is, in the example shown in FIG. 15, the electrode 31 and the electrode 32 are comb-teeth electrodes formed on the upper surface of the piezoelectric film 11. On the other hand, although not shown, the electrode 31 and the electrode 32 as comb-type electrodes may be formed on the lower surface of the piezoelectric film 11. That is, the electrode 31 and the electrode 32 may be comb-teeth electrodes formed on the lower surface of the piezoelectric film 11.

Since the polarization direction of the piezoelectric film 11 is preferentially oriented perpendicularly to the substrate 12, the polarization direction of the piezoelectric film 11 and a direction of the comb-type electrode preferably intersect with each other at right angles.

Here, the comb-type electrode, that is, the electrode 31 as a comb-teeth electrode includes a main body 31a extending in a direction DR1 in plan view, and a plurality of comb teeth 31b protruding from the main body 31a in a direction DR2 that intersects and preferably perpendicularly intersects with the direction DR1 in plan view, extending in the direction DR2 in plan view, and arranged in the direction DR1. The comb-type electrode, that is, the electrode 32 as a comb-teeth electrode includes a main body 32a extending in the direction DR1 in plan view, and a plurality of comb teeth 32b protruding from the main body 32a in the direction DR2 that intersects and preferably perpendicularly intersects with the direction DR1 in plan view, extending in the direction DR2 in plan view, and arranged in the direction DR1. The comb teeth 31b and the comb teeth 32b are alternately arranged along the direction DR1. In such a case, a direction of the comb-type electrode is the direction DR2 in which the comb teeth 31b and the comb teeth 32b extend, and the polarization direction DP1 of the piezoelectric film 11 is a direction that intersects and preferably perpendicularly intersects with the direction DR2 which is the direction in which the comb teeth 31b and the comb teeth 32b extend.

As described above, the film structure 10 provided in the electronic device 30 of the present Embodiment 3 may also include the piezoelectric film 11, and the substrate 12, similar to the film structure 10 of Embodiment 1. Therefore, in the film structure 10 provided in the electronic device 30 of the present Embodiment 3, as in the film structure 10 of Embodiment 1, the substrate 12 may also have a structure in which a Si layer and a $ZrO_2$ layer are laminated in this order, an SOI substrate which is a semi-conductor substrate may also be used instead of the Si substrate as the Si layer 12a (see FIG. 6) of the substrate 12, and the electrode 13 may also include the Mo layer 13c (see FIG. 3) or the W layer 13d (see FIG. 3) instead of the Pt layer 13a (see FIG. 3). In addition to the materials described above, a Ru layer or a Cu layer may be used as the material for the electrodes 13a, 13c, or 13d.

In the film structure 10 provided in the electronic device 30 of the present Embodiment 3, as in the film structure 10 of Embodiment 1, the piezoelectric film 11 contains c-axis oriented lithium niobate ($LiNbO_3$) or lithium tantalate ($LiTaO_3$), that is, contains c-axis $LiNbO_3$ or $LiTaO_3$ as a main component.

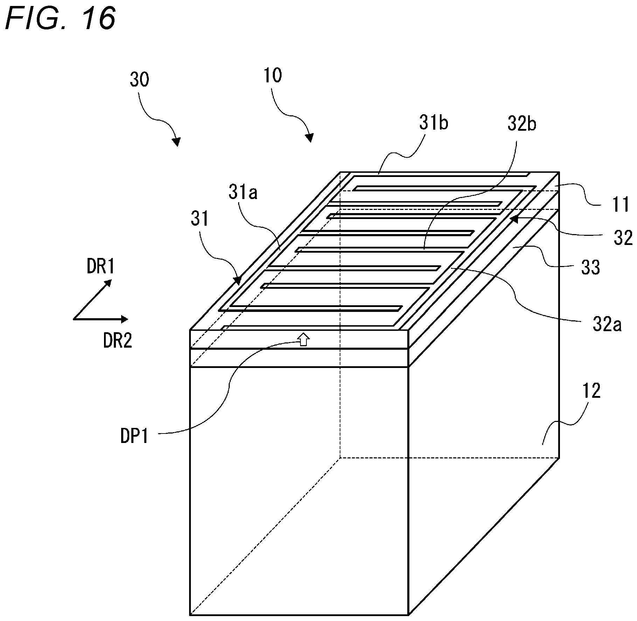

As shown in FIG. 16, it is preferable to provide a dielectric layer or a dielectric layer 33 as a matching layer between the substrate 12 and the piezoelectric film 11. That is, the electronic device 30 shown in FIG. 16 includes, in addition to the portions of the electronic device 30 shown in FIG. 15, the dielectric layer 33 as a matching layer formed above the substrate 12 and below the piezoelectric film 11. Thus, acoustic matching between the substrate 12 and the piezoelectric film 11 can be achieved. For example, when a portion of the electronic device 30 other than the dielectric layer 33 is made of a material having a property of being softened together with an increase in temperature and the dielectric layer 33 is made of a material having a property of being hardened together with an increase in temperature, the temperature dependence of the dielectric constant characteristic or piezoelectric characteristic of the electronic device 30, that is, the temperature characteristics can be stabilized or adjusted.

The dielectric layer 33 is preferably a Si compound, for example, $SiO_2$. In such a case, the dielectric layer 33 is a dielectric layer made of a material that is highly compatible with a manufacturing process of a semi-conductor device, and thus the dielectric layer 33 can be easily formed.

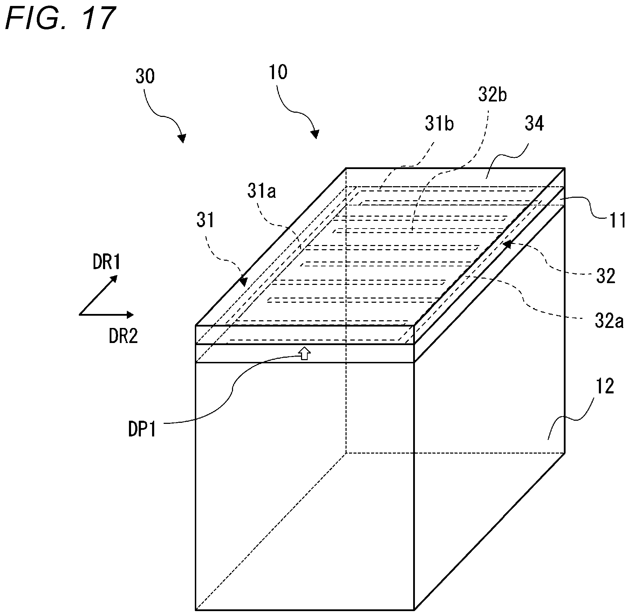

As shown in FIG. 17, it is preferable to provide a dielectric layer 34 above the piezoelectric film 11. That is, the electronic device 30 shown in FIG. 17 includes, in addition to the portions of the electronic device 30 shown in FIG. 15, the dielectric layer 34 as a matching layer above the piezoelectric film 11. Thus, acoustic matching between the substrate 12 and the piezoelectric film 11 can be achieved. For example, when a portion of the electronic device 30 other than the dielectric layer 34 is made of a material having a property of being softened together with an increase in temperature and the dielectric layer 34 is made of a material having a property of being hardened together with an increase in temperature, the temperature dependence of the dielectric constant characteristic or piezoelectric characteristic of the electronic device 30, that is, the temperature characteristics can be stabilized or adjusted.

The dielectric layer 34 is preferably a Si compound, for example, $SiO_2$. In such a case, the dielectric layer 34 is a dielectric layer made of a material that is highly compatible with a manufacturing process of a semi-conductor device, and thus the dielectric layer 34 can be easily formed.

EXAMPLES

Hereinafter, the present embodiment will be described in more detail based on Examples. The present invention is not limited to the following Examples.

(Example 1 to Example 3)

Hereinafter, a test was performed in which the film structure 10 described in Embodiment 1 using FIGS. 1 to 6 was formed as a film structure in Example 1 to Example 3, and the piezoelectric film 11 made of c-axis oriented $LiNbO_3$ was formed on the Si layer 12a made of a Si substrate with the $ZrO_2$ layer 12b therebetween. At this time, as shown in FIG. 3, a film structure in which the Pt layer 13a and the SRO layer 13b were formed between the $ZrO_2$ layer 12b and the piezoelectric film 11 in this order from a Si layer 12a side was defined as Example 1, as shown in FIG. 4, a film structure in which only the Pt layer 13a was formed between the $ZrO_2$ layer 12b and the piezoelectric film 11 was defined as Example 2, and as shown in FIG. 5, a film structure in which the piezoelectric film 11 made of c-axis oriented $LiNbO_3$ was directly formed on the $ZrO_2$ layer 12b was defined as Example 3.

[Formation of Film Structure]

A method for forming the film structure in Example 1 will be described. First, as the Si layer 12a (see FIG. 3) made of a Si(100) substrate, a wafer made of a 6-inch silicon single crystal and having an upper surface made of a (100) plane was prepared.

Next, the $ZrO_2$ layer 12b (see FIG. 3) was formed on the wafer as the Si layer 12a (see FIG. 3) by electron beam evaporation. Conditions at this time are shown below.

Device: electron beam evaporation device
Pressure:

$$7.00 \times 10^{-5} \ Pa$$

Evaporation source: Zr + $O_2$
Acceleration voltage/emission current: 7.5 kV/1.80 mA
Thickness: 60 nm
Substrate temperature: 500°C

Next, the Pt layer 13a (see FIG. 3) was formed on the $ZrO_2$ layer 12b (see FIG. 3) by sputtering. Conditions at this time are shown below.

Device: DC sputtering device

Pressure:

$$1.20 \times 10^{-1} \ Pa$$

Evaporation source: Pt
Electric power: 100 W
Thickness: 150 nm
Substrate temperature: 450°C to 600°C

Next, the Pt layer 13a (see FIG. 3) was formed on the SRO layer 13b (see FIG. 3) by sputtering. Conditions at this time are shown below.

Device: RF magnetron sputtering device
Power: 300 W
Gas: Ar
Pressure: 1.8 Pa
Substrate temperature: 600°C
Thickness: 40 nm

Next, the piezoelectric film 11 (see FIG. 3) made of $LiNbO_3$ was formed on the SRO layer 13b (see FIG. 3) by sputtering. Conditions at this time are shown below.

Device: AC sputtering device
Pressure: 2 Pa
Evaporation source (target): $LiNbO_3$
Gas: $Ar/N_2$
Power: 1000 W
Substrate temperature: 450°C
Thickness: 500 nm

On the other hand, in a method for forming the film structure in Example 2, unlike the method for forming the film structure in Example 1, the SRO layer 13b (see FIG. 3) was not formed, and the piezoelectric film 11 (see FIG. 4) was directly formed on the Pt layer 13a (see FIG. 4). In the method for forming the film structure in Example 3, unlike the method for forming the film structure in Example 1, the Pt layer 13a and the SRO layer 13b were not formed, and the piezoelectric film 11 was directly formed on the $ZrO_2$ layer 12b.

[Out-of-plane Measurement]

For the film structures in Example 1 to Example 3, an $\omega$-$2\theta$ spectrum (out-of-plane X-ray diffraction pattern) was measured by an XRD method. That is, an X-ray diffraction measurement (out-of-plane measurement) by $\omega$-$2\theta$ scan was performed on the film structures in Example 1 to Example 3 in which the piezoelectric film 11 was already formed. The out-of-plane measurement corresponds to a case where an angle between a measurement surface and a substrate surface is less than 90°. XRD data for Example 1 to Example 3 are obtained by using an X-ray diffractometer Smart Lab manufactured by Rigaku.

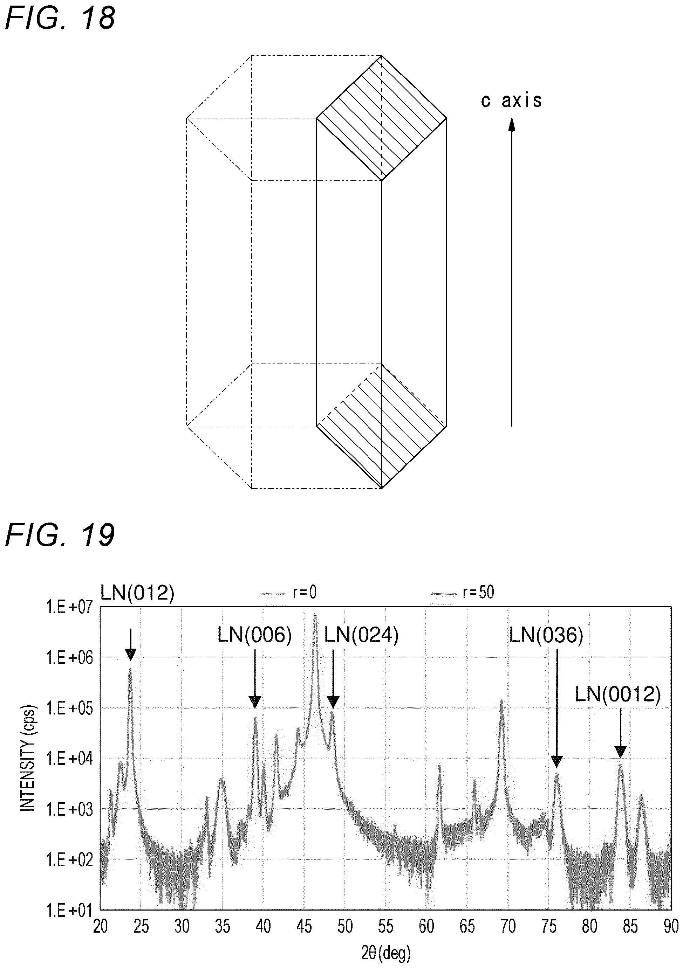

FIG. 18 shows a definition of a c-axis oriented plane. FIG. 18 is a diagram showing a crystal structure of c-axis oriented $LiNbO_3$. As described above, $LiNbO_3$ has an ilmenite structure, which is a trigonal crystal structure, and is polarized in a c-axis direction. In FIG. 18, a shaded portion represents a c-plane, and a c-axis represents a c(001) axis.

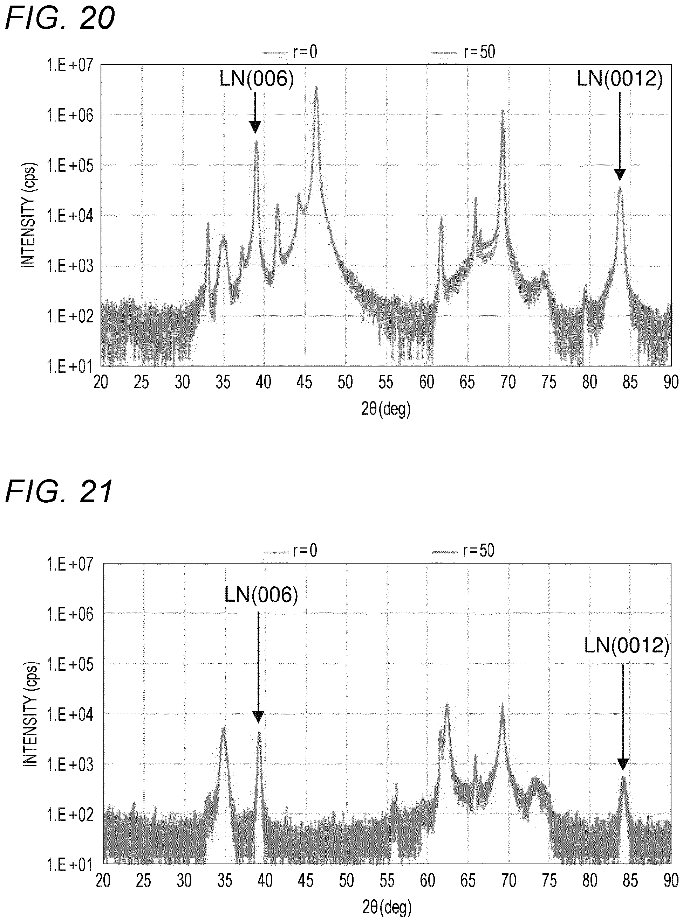

FIG. 19 is a graph showing an example of the ω-2θ spectrum of the film structure in Example 1, which is obtained by the XRD method. FIG. 20 is a graph showing an example of the ω-2θ spectrum of the film structure in Example 2, which is obtained by the XRD method. FIG. 21 is a graph showing an example of the ω-2θ spectrum of the film structure in Example 3, which is obtained by the XRD method. A horizontal axis in the graphs of FIGS. 19 to 21 indicates an angle 2θ in the ω-2θ scan, and a vertical axis in the graphs of FIGS. 19 to 21 indicates an intensity of detected X-rays. FIGS. 19 to 21 show a range of $20° \leq 2θ \leq 90°$.

In any of the ω-2θ spectra of the example (Example 1) shown in FIG. 19, the example (Example 2) shown in FIG. 20, and the example (Example 3) shown in FIG. 21, in addition to a peak corresponding to a Si(400) plane around 69°, peaks corresponding to a (006) plane ((0, 0, 6) plane) and a (0012) plane ((0, 0, 12) plane) of LN were observed in three-exponent representation. In the ω-2θ spectra of the example (Example 1) shown in FIG. 19 and the example (Example 2) shown in FIG. 20, a peak corresponding to a (200) plane of Pt around 46° was observed. Therefore, it was confirmed that, in the film structures in Example 1 and Example 2, the Pt layer 13a was (200)-oriented, that is, (100)-oriented on the Si layer 12a made of a Si(100) substrate, and the piezoelectric film 11 made of c-axis oriented $LiNbO_3$ was formed on the Pt layer 13a. It was confirmed that, in the film structure in Example 3, the piezoelectric film 11 made of c-axis oriented $LiNbO_3$ was formed on the Si layer 12a made of a Si(100) substrate.

When comparing FIGS. 19 to 21, in the ω-2θ spectrum of the example (Example 2) shown in FIG. 20, an intensity of a diffraction peak of the (006) plane of LN was the largest in the three-exponent representation.

In the ω-2θ spectrum of the example (Example 1) shown in FIG. 19, peaks corresponding to a (012) plane ((0, 1, 2) plane), a (024) plane ((0, 2, 4) plane), and a (036) plane ((0, 3, 6) plane) of LN were observed in the three-exponent representation. Therefore, in the film structure in Example 1, unlike the film structures in Example 2 and Example 3, the piezoelectric film 11 contained a component made of (012)-oriented $LiNbO_3$ in the three-exponent representation in addition to a component made of c-axis oriented $LiNbO_3$.

[Reciprocal Lattice Map Measurement]

Next, the film structures in Example 1 and Example 2 were subjected to a reciprocal lattice map measurement. The reciprocal lattice map measurement is a method for three-dimensionally observing a film to be measured and confirming a fluctuation in lattice constant and an inclination of a lattice plane.

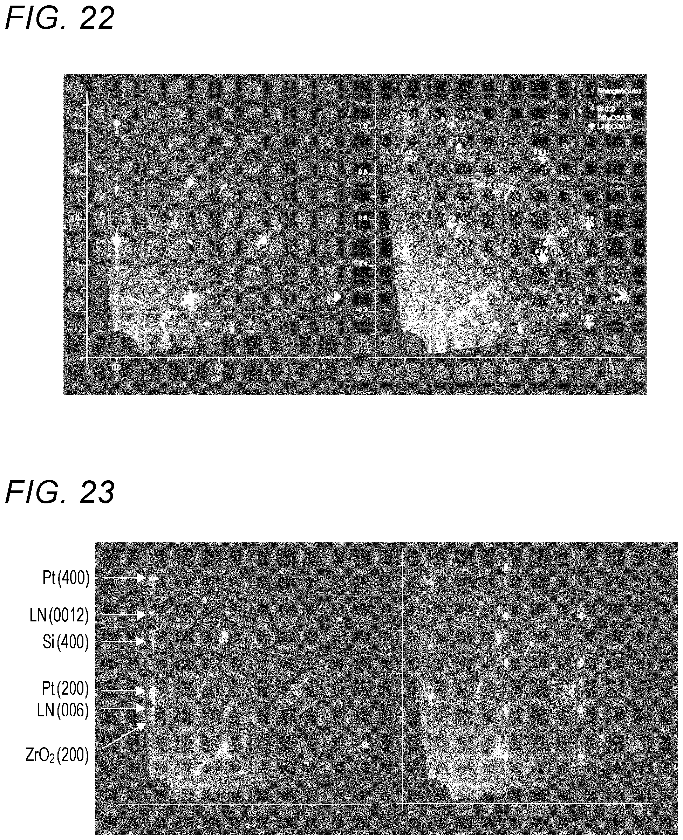

FIG. 22 is a graph showing a result of the reciprocal lattice map measurement of the film structure in Example 1. FIG. 23 is a graph showing a result of the reciprocal lattice map measurement of the film structure in Example 2. In each of FIGS. 22 and 23, a result of the reciprocal lattice map measurement is shown in the left half, and a result obtained by superimposing a simulation result on the result of the reciprocal lattice map measurement is shown in the right half. As a representative of FIGS. 22 and 23, FIG. 23 shows a plurality of reciprocal lattice points representing a Si(400) plane, a $ZrO_2(200)$ plane, a Pt(200) plane, a Pt(400) plane, and an LN(006) plane and LN(0012) plane in the three-exponent representation, respectively.

In each of the example (Example 1) shown in FIG. 22 and the example (Example 2) shown in FIG. 23, six reciprocal lattice points representing the $ZrO_2(200)$ plane, the LN(006) plane, the Pt(200) plane, the Si(400) plane, and the LN(0012) plane and Pt(400) plane in the three-exponent representation, respectively, were confirmed in a vertical line, and the planes were aligned. That is, in X-ray reciprocal lattice space mapping of each of the film structures in Example 1 and Example 2, six reciprocal lattice points representing the $ZrO_2(200)$ plane, the LN(006) plane, the Pt(200) plane, the Si(400) plane, and the LN(0012) plane and Pt(400) plane in the three-exponent representation, respectively, were arranged in a Qz direction. In the example (Example 2) shown in FIG. 23, since the reciprocal lattice points are clear, it can be said that there is less fluctuation compared to the example (Example 1) shown in FIG. 22. Although not shown, similar results were obtained for the film structure in Example 3.

From the above results, it was found that in any of the film structures in Example 1 to Example 3, $LiNbO_3$ is c-axis oriented and epitaxially grown on the Si layer 12a made of a Si(100) substrate. It was also found that there was no crystal fluctuation in $LiNbO_3$ and lattice planes were aligned. That is, it was found that $LiNbO_3$ formed on $SRO(100)/Pt(100)/ZrO_2/Si(100)$, $Pt(100)/ZrO_2/Si(100)$, and $ZrO_2/Si(100)$ was c-axis oriented and approximately single crystallized.

[In-plane Measurement]

Next, for the film structures in Example 1 and Example 2, an φ scan spectrum ((in-plane X-ray diffraction pattern) was measured by the XRD method. That is, an X-ray diffraction measurement (in-plane measurement) by an φ scan was performed on the film structures in Example 1 and Example 2 in which the piezoelectric film 11 was already formed. The in-plane measurement corresponds to a case where an angle between a measurement surface and a substrate surface is equal to 90°.

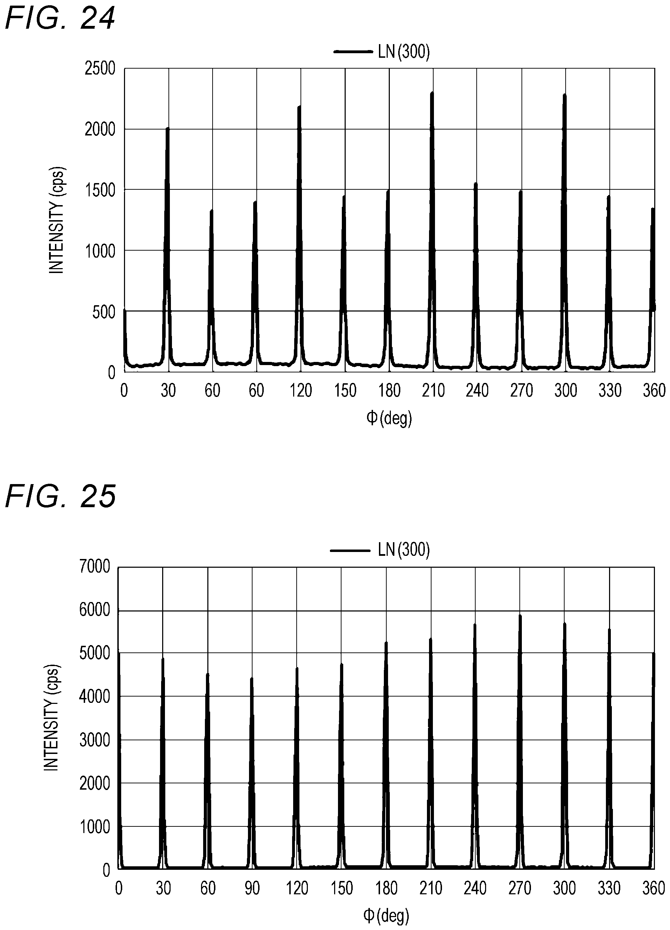

FIG. 24 is a graph showing an example of the φ scan spectrum of the film structure in Example 1, which is obtained by the XRD method. FIG. 25 is a graph showing an example of the φ scan spectrum of the film structure in Example 2, which is obtained by the XRD method. A horizontal axis in the graphs of FIGS. 24 and 25 indicates an angle φ in the φ scan, and a vertical axis in the graphs of FIGS. 24 and 25 indicates an intensity of detected X-rays. FIGS. 24 and 25 show a range of $0° \leq φ \leq 360°$.

In the examples shown in FIGS. 24 and 25, the φ scan is performed in a state where the angle between the measurement surface and the substrate surface is around 90° (in-plane measurement) and 2θ is adjusted to be equal to an angle (62.4°) corresponding to a diffraction peak of an LN(300) plane in the three-exponent representation.

In both the φ scan of the example (Example 1) shown in FIG. 24 and the φ scan of the example (Example 2) shown in FIG. 25, twelve diffraction peaks were observed that were arranged at an interval of 30° in an φ direction (horizontal axis direction) and each represented the LN(300) plane in the three-exponent representation. Therefore, it was revealed that, in the film structures in Example 1 and Example 2, LiNbO$_3$ had 12-fold symmetry as apparent crystal structure symmetry. Although not shown, similar results were obtained for the film structure in Example 3.

Therefore, from the φ scan spectrum, as in the reciprocal lattice map measurement, it was revealed that LiNbO$_3$ was epitaxially grown on the Si layer 12a made of a Si(100) substrate in the film structures in Example 1 to Example 3. On the other hand, as shown in FIG. 18, the crystal structure of LiNbO$_3$ has 3-fold symmetry about the c-axis. Therefore, it is considered that the piezoelectric film 11 in each of the film structures in Example 1 to Example 3 includes a plurality of different domains (rotational components) rotated with respect to each other in the LN(006) plane.

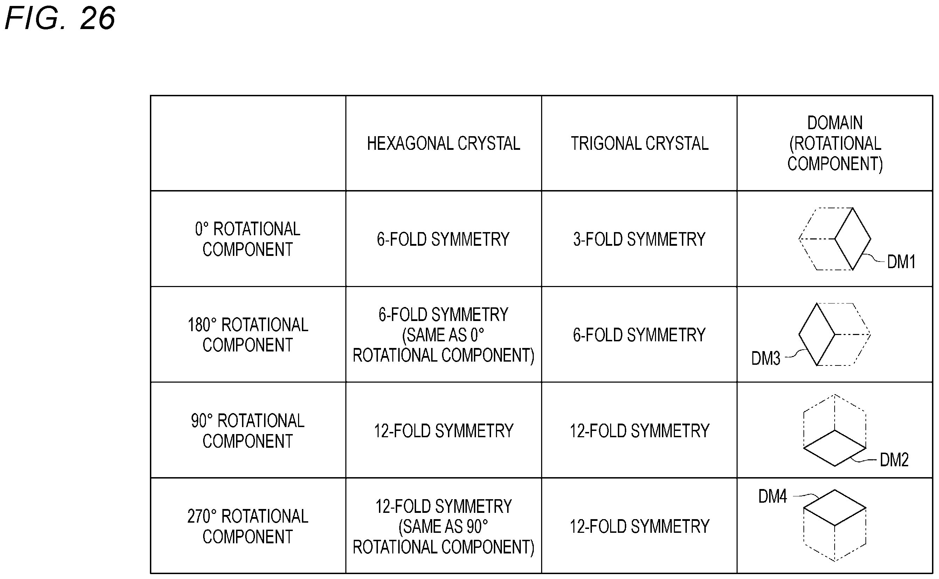

FIG. 26 shows a table in which symmetry of an apparent crystal structure determined by the number of diffraction peaks observed in the φ scan spectrum is classified and sorted by a rotational angle of a rotational component and symmetry of a crystal structure including a hexagonal crystal and a trigonal crystal. In FIG. 26, a reference domain (rotational component) is denoted as "0° rotational component", and domains (rotational components) rotated by 180°, 90°, and 270° from the reference domain are denoted as "180° rotational component", "90° rotational component", and "270° rotational component", respectively.

As shown in FIG. 26, in the crystal structure composed of the trigonal crystal, the case of having 12-fold symmetry is the case of having a domain (rotational component) rotated by 90° from the reference domain or the case of having a domain (rotational component) rotated by 270° from the reference domain. In the crystal structure composed of the trigonal crystal, the case of having a domain (rotational component) rotated by 270° from the reference domain is the same as the case of having a domain (rotational component) rotated by 90° from the reference domain. Accordingly, from the φ scan spectra shown in FIGS. 24 and 25, it is considered that the film structures in Examples 1 to 3 have four domains (rotational components) including a reference domain and three domains rotated by 90°, 180°, and 270° from the reference domain.

Here, four different rotational components of the piezoelectric film 11 are referred to as portions DM1 to DM4. It is considered that, due to the existence of the portions DM1 to DM4, in the φ scan shown in FIGS. 24 and 25, four sets of three diffraction peaks having 3-fold symmetry are overlapped with being shifted by 90° from each other, and thus twelve diffraction peaks having 12-fold symmetry are observed. In such a case, as shown in FIG. 26, the portion DM1 can be set as a 0° rotational component, the portion DM2 can be set as a 90° rotational component, the portion DM3 can be set as a 180° rotational component, and the portion DM4 can be set as a 270° rotational component.

The above results are summarized as follows. The Si substrate serving as the Si layer 12a is a Si(100) substrate, or the SOI layer serving as the Si layer 12a is an LN film made of a Si(100) film, and the piezoelectric film 11 is a c-axis oriented LiNbO$_3$ film. In such a case, the LN film preferably has the epitaxially grown portions DM1 to DM4, the portion DM2 is rotated clockwise by 90° about the c-axis with respect to the portion DM1, the portion DM3 is rotated clockwise by 180° about the c-axis with respect to the portion DM1, and the portion DM4 is rotated clockwise by 270° about the c-axis with respect to the portion DM1.

[Voltage Dependence of Polarization]

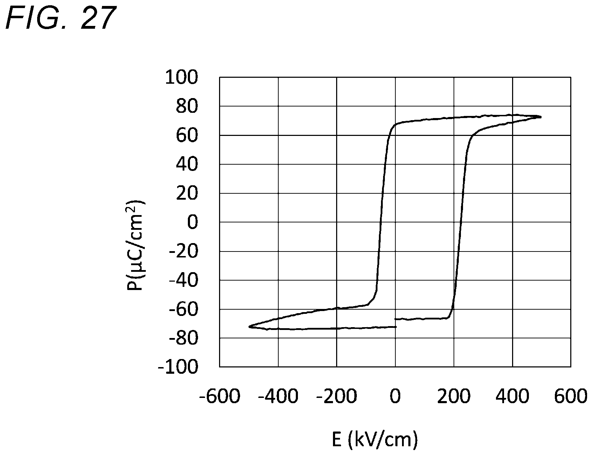

In the film structure in Example 2, an upper electrode made of Pt was formed on the piezoelectric film 11 (see FIG. 4), and a voltage was applied between the electrode 13 (see FIG. 4) and the upper electrode to measure voltage dependence of polarization (polarization voltage hysteresis curve). FIG. 27 is a graph showing voltage dependence of polarization of the film structure in Example 2. A value of polarization when the voltage applied to the piezoelectric film 11 is increased from 0 to a positive side and returned to 0 again is a residual polarization value of the piezoelectric film 11.

As shown in FIG. 27, the graph showing the voltage dependence of the polarization of the film structure in Example 2 shows a polarization voltage hysteresis curve showing ferroelectricity of the piezoelectric film 11, and the piezoelectric film 11 has large residual polarization of about 70 μC/cm$^2$ in the polarization voltage hysteresis curve. Even in the initial state, the piezoelectric film 11 has large spontaneous polarization of about -70 μC/cm$^2$. Therefore, when the film structure in Example 2 is used as a piezoelectric element, it is not necessary to apply a polarization process to the piezoelectric film 11 before use. Although not shown, substantially the same results were obtained in the film structures in Example 1 and Example 3. Therefore, it was shown that the piezoelectric film 11 had good ferroelectricity in the film structures in Example 1 to Example 3. Since the piezoelectric film 11 has ferroelectricity and a polarization action, it can also be effectively used for memory.

Although the invention made by the present inventor has been specifically described based on the embodiments, the present invention is not limited to the embodiments, and it is needless to say that various modifications can be made without departing from the gist of the invention.

It is understood that various changes and modifications can be conceived by those skilled in the art within the scope of the spirit of the present invention, and the changes and modifications also belong to the scope of the present invention.

For example, addition, deletion, or design change of a component, or addition, omission, or condition change of a process made by those skilled in the art to each of the above-described embodiments, as appropriate, are also included in the scope of the present invention as long as the gist of the present invention is included.

REFERENCE SIGNS LIST

10 film structure
11 piezoelectric film
12 substrate
12a Si layer
12b ZrO$_2$ layer
12c base
12d BOX layer
13, 22, 22a, 22b, 31, 32 electrode
13a Pt layer
13b SRO layer
13c Mo layer
13d W layer
20, 30 electronic device
21 hollow portion
23, 24, 33, 34 dielectric layer
31a, 32a main body
31b, 32b comb teeth
DM1 to DM4 portion
DP1 polarization direction
DR1, DR2 direction

**Claims**

1. A film structure comprising:

   a substrate;
   a buffer film formed over the substrate; and
   a piezoelectric film formed over the buffer film, wherein

   the substrate is a Si(100) substrate or an SOI substrate including a base made from a Si substrate, an insulating layer over the base, and an SOI layer made from a Si(100) film over the insulating layer,
   the buffer film contains ZrO$_2$, and
   the piezoelectric film contains c-axis oriented LiNbO$_3$ or LiTaO$_3$.

2. The film structure according to claim 1, further comprising:
   a metal film formed between the buffer film and the piezoelectric film.

3. The film structure according to claim 2, wherein the metal film contains (100)-oriented Pt.

4. The film structure according to claim 2, wherein the metal film is a Pt film, a Mo film, a W film, a Ru film, or a Cu film.

5. The film structure according to claim 3, further comprising:

   a SrRuO$_3$ film formed between the metal film and the piezoelectric film, wherein
   the SrRuO$_3$ film has a cubic crystal structure and is (100)-oriented.

6. An electronic device comprising:
   the film structure according to any one of claims 1 to 5.

7. An electronic device comprising:

   the film structure according to claim 1, wherein the film structure comprises a comb-teeth electrode formed at an upper surface or a lower surface of the piezoelectric film.

8. The electronic device according to claim 7, wherein the film structure comprises a matching layer formed over the substrate.

9. The electronic device according to claim 6, wherein a hollow portion is provided below the piezoelectric film.

10. The electronic device according to claim 9, wherein the film structure comprises an upper electrode formed above the piezoelectric film and a lower electrode formed below the piezoelectric film.

11. The electronic device according to claim 10, wherein an area of an overlapping portion of the upper electrode and the lower electrode is smaller than an area of the hollow portion.

**12.** The electronic device according to claim 10, wherein an area of an overlapping portion of the upper electrode and the lower electrode is equal to or smaller than 1/2 of an area of the hollow portion.

**13.** The electronic device according to claim 9, wherein the film structure comprises a matching layer formed over the substrate.

**14.** The electronic device according to claim 8, wherein the matching layer is made from a material whose hardness increases with an increase in temperature.

**15.** The electronic device according to claim 14, wherein the material is a Si compound.

*FIG. 1*

*FIG. 2*

*FIG. 3*

10

11

13b
13a,
13c,
13d
13

12b
12
12a

*FIG. 4*

10

11

13, 13a,
13c,
13d

12b
12
12a

*FIG. 5*

*FIG. 6*

FIG. 7

*FIG. 8*

## FIG. 9

*FIG. 10*

## FIG. 11

## FIG. 12

## FIG. 13

## FIG. 14

# FIG. 15

FIG. 16

*FIG. 17*

## FIG. 18

c axis

## FIG. 19

## FIG. 20

## FIG. 21

FIG. 22

FIG. 23

Pt(400)

LN(0012)

Si(400)

Pt(200)
LN(006)

ZrO$_2$(200)

## FIG. 24

## FIG. 25

# FIG. 26

| | HEXAGONAL CRYSTAL | TRIGONAL CRYSTAL | DOMAIN (ROTATIONAL COMPONENT) |
|---|---|---|---|
| 0° ROTATIONAL COMPONENT | 6-FOLD SYMMETRY | 3-FOLD SYMMETRY | DM1 |
| 180° ROTATIONAL COMPONENT | 6-FOLD SYMMETRY (SAME AS 0° ROTATIONAL COMPONENT) | 6-FOLD SYMMETRY | DM3 |
| 90° ROTATIONAL COMPONENT | 12-FOLD SYMMETRY | 12-FOLD SYMMETRY | DM2 |
| 270° ROTATIONAL COMPONENT | 12-FOLD SYMMETRY (SAME AS 90° ROTATIONAL COMPONENT) | 12-FOLD SYMMETRY | DM4 |

FIG. 27

## INTERNATIONAL SEARCH REPORT

| International application No. |
|---|
| **PCT/JP2023/014441** |

**A.    CLASSIFICATION OF SUBJECT MATTER**

*H10N 30/079*(2023.01)i; *H03H 9/17*(2006.01)i; *H03H 9/25*(2006.01)i; *H10N 30/40*(2023.01)i; *H10N 30/85*(2023.01)i; *H10N 30/853*(2023.01)i

FI:    H10N30/079; H03H9/17 F; H03H9/25 C; H10N30/40; H10N30/85; H10N30/853

According to International Patent Classification (IPC) or to both national classification and IPC

**B.    FIELDS SEARCHED**

Minimum documentation searched (classification system followed by classification symbols)

H10N30/079; H03H9/17; H03H9/25; H10N30/40; H10N30/85; H10N30/853

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | JP 2021-64735 A (TDK CORP.) 22 April 2021 (2021-04-22) paragraphs [0016], [0018], [0026], [0027], [0030], [0046], [0055], [0102], fig. 1-6 | 1-6, 9, 10 |
| Y | | 7, 8, 11-15 |
| X | WO 2020/179210 A1 (ADVANCED MATERIAL TECHNOLOGIES CO., LTD.) 10 September 2020 (2020-09-10) paragraphs [0002], [0014]-[0016], [0022], [0023], [0026], [0079], fig. 1-36 | 1-6 |
| Y | | 7, 8, 14, 15 |
| A | | 9-13 |
| Y | US 2021/0111689 A1 (SKYWORKS SOLUTIONS, INC.) 15 April 2021 (2021-04-15) paragraphs [0088], [0092], [0096], [0114], [0118], fig. 1-13 | 7, 8, 14, 15 |
| Y | WO 2002/093549 A1 (UBE ELECTRONICS, LTD.) 21 November 2002 (2002-11-21) p. 5, lines 43-45, p. 19, line 40 to p. 28, lines 32-47, fig. 1-29 | 11-13 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **28 June 2023** | **11 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

International application No.

**PCT/JP2023/014441**

| Patent document cited in search report | | | Publication date (day/month/year) | Patent family member(s) | Publication date (day/month/year) |
|---|---|---|---|---|---|
| JP | 2021-64735 | A | 22 April 2021 | (Family: none) | |
| WO | 2020/179210 | A1 | 10 September 2020 | US 2022/0181541 A1 paragraphs [0002], [0065]-[0067], [0073], [0074], [0077], [0158], fig. 1-36 EP 3937265 A1 | |
| US | 2021/0111689 | A1 | 15 April 2021 | (Family: none) | |
| WO | 2002/093549 | A1 | 21 November 2002 | US 2002/0190814 A1 paragraphs [0002], [0155], [0257],[0258], fig. 1-29 | |

Form PCT/ISA/210 (patent family annex) (January 2015)

**EP 4 498 785 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2013173647 A

- JP 2016109856 A